# FASCICULE DE BREVET EUROPEEN

(11) **EP 2 835 671 B1**
(45) Date de publication et mention de la délivrance du brevet: **30.01.2019**
(21) Numéro de dépôt: 14179954.4
(22) Date de dépôt: 06.08.2014
(51) Int. Cl.: G02B 5/28, H01L 31/0216, H01L 27/146

(54) **Procédé de réalisation d'un filtre optique multicouches épais au sein d'un circuit intégré, et circuit intégré comprenant un filtre optique multicouches épais**
Verfahren zur Herstellung eine dicken mehrschichtigen optischen Filters in einem integrierten Schaltkreis, und integrierter Schaltkreis, der einen solchen dicken mehrschichtigen optischen Filter umfasst
Method for manufacturing a thick multilayer optical filter within an integrated circuit, and integrated circuit comprising a thick multilayer optical filter

(30) Priorité: 08.08.2013 FR 1357901
(43) Date de publication de la demande: 11.02.2015
(73) Titulaire: STmicroelectronics SA, 92120 Montrouge (FR); COMMISSARIAT À L'ÉNERGIE ATOMIQUE ET AUX ÉNERGIES ALTERNATIVES, 75015 Paris (FR)
(72) Inventeur: Frey, Laurent, 38600 Fontaine (FR); Marty, Michel, 38760 Saint Paul de Varces (FR)
(74) Mandataire: Casalonga

(56) Documents cités:
- WO-A1-2008/012235
- US-A1- 2008 108 170
- US-A1- 2010 308 427
- US-A1- 2011 032 398

## Description

L'invention concerne la formation d'empilements de matériaux différents, en particulier pour la formation de filtres optiques multicouches destinés à filtrer, c'est-à-dire laisser passer, différents rayonnements lumineux du domaine visible ou infrarouge, et qui sont utilisés dans des dispositifs imageurs.

Les dispositifs imageurs comprennent généralement un ensemble de pixels ayant chacun une zone photosensible semiconductrice disposée sous un filtre optique intégré au sein du dispositif imageur, par exemple un filtre coloré. On pourra notamment utiliser des groupes de pixels avec des filtres rouges, verts et bleus, par exemple de manière à former des motifs de Bayer bien connus de l'homme du métier.

Les filtres optiques destinés à ne laisser passer qu'une seule couleur comprennent généralement un filtre de résine colorée par des pigments. Ces filtres ont pour inconvénient de ne pas être suffisamment robustes et de ne pas être suffisamment sélectifs par rapport à certains rayonnements, notamment les rayonnements infrarouge.

Il a donc été proposé des alternatives aux résines pigmentées.

On connaît également des filtres optiques multicouches, parfois appelés résonants, pour filtrer un rayonnement. Ces filtres optiques multicouches comprennent une couche d'un matériau diélectrique généralement disposée entre deux couches métalliques pour former des filtres. L'épaisseur et les caractéristiques optiques de cette couche diélectrique déterminent notamment la fréquence de résonance du résonateur et elles déterminent ainsi la longueur d'onde des photons qui peuvent atteindre une zone photosensible disposée sous le filtre. Ces filtres multicouches peuvent être des filtres destinés à laisser passer les couleurs visibles ou encore les rayonnements infrarouges. Ils peuvent notamment être disposés au dessus de dispositifs imageurs tels que des photodiodes à avalanche déclenchées par un photon individuel (« Single Photon Avalanche Diode » en langue anglaise).

On pourra se référer au document WO 2008/012235 qui décrit un dispositif imageur comportant des filtres multicouches métal/diélectrique formés au dessus d'une partie d'interconnexion d'un circuit intégré, au dessus de zones photosensibles. Cette partie d'interconnexion est couramment désignée par l'acronyme anglo-saxon de « BEOL : Back End Of Line ». Les filtres multicouches décrits dans ce document ont pour inconvénient d'avoir une transmission au voisinage de la longueur d'onde à laisser passer pas assez importante. Ces filtres multicouches ont également pour inconvénient de présenter une réjection pas assez forte des longueurs que l'on souhaite bloquer.

Les documents US2011/0032398, US2010/0308427 et US2008/0108170 font £galement partie de l'art antérieur.

Selon un mode de mise en oeuvre et de réalisation, il est proposé un procédé de réalisation d'un filtre optique multicouches, et d'un circuit intégré comprenant un filtre optique multicouches, le filtre optique ayant une transmission au voisinage de longueur d'onde à laisser passer améliorée, et une réjection importante pour les autres longueurs d'onde.

Ce procédé est définie par la revendication 1.

Selon un aspect, il est proposé un procédé de réalisation d'un filtre optique multicouches au sein d'un circuit intégré comprenant un substrat et une partie d'interconnexion.

Selon une caractéristique générale de cet aspect, la réalisation du filtre optique comprend une formation d'une première partie de filtre à l'intérieur de la partie d'interconnexion au dessus d'une zone photosensible située dans le substrat, et une formation d'une deuxième partie de filtre au dessus de la première partie de filtre et de la partie d'interconnexion.

Contrairement aux filtres selon l'art antérieur, ici, une partie du filtre est enfouie dans la partie d'interconnexion. On peut ainsi former un filtre ayant une épaisseur totale plus importante, et en particulier une épaisseur de cavité résonante plus importante, ce qui permet d'améliorer les propriétés optiques du filtre.

Les inventeurs ont observé qu'en augmentant l'épaisseur des filtres optique multicouches, en particulier l'épaisseur séparant les deux les couches métalliques d'un filtre, on améliore les propriétés optiques de ce filtre. En outre, les inventeurs ont observé qu'il était particulièrement intéressant de placer l'une des couches métalliques dans la partie d'interconnexion pour augmenter l'épaisseur totale du filtre, sans augmenter l'épaisseur du filtre au dessus de la partie d'interconnexion. En effet cette épaisseur au-dessus de la partie d'interconnexion est généralement limitée par l'épaisseur de résine photosensible nécessaire à la gravure du filtre, et également par la taille des pixels.

Par ailleurs, le filtre multicouches est avantageusement ici un seul filtre comportant deux parties, inférieure et supérieure, séparées par des couches, généralement épaisses, de la partie d'interconnexion dont les épaisseurs sont de préférence choisies pour optimiser les interférences globales générées dans l'ensemble du filtre. Les interférences ayant lieu dans chacune des deux parties du filtre sont mutuellement corrélées, en particulier car toutes les interfaces entre les parties du filtre sont planes et donc parallèles entre elles.

La formation de la première partie de filtre peut comprendre :
- une formation d'une région inférieure de la partie d'interconnexion au dessus de la zone photosensible, et
- une formation d'une couche métallique inférieure de filtre optique au-dessus de la région inférieure d'interconnexion et de la zone photosensible.

La formation de la deuxième partie de filtre peut comprendre :
- une formation d'une région supérieure de la partie d'interconnexion au-dessus de la couche métallique inférieure de filtre optique et de la région inférieure d'interconnexion, et
- une formation d'une couche métallique supérieure de filtre optique au-dessus de la région supérieure d'interconnexion et de la couche métallique inférieure de filtre optique.

En formant la couche métallique inférieure, qui forme la première partie de filtre, au dessus d'une faible épaisseur de région inférieure d'interconnexion, et en formant la couche métallique supérieure, qui forme la deuxième partie de filtre, au dessus d'une épaisseur importante de région supérieure d'interconnexion, on peut espacer les deux couches métalliques.

La formation de la première partie de filtre et la formation de la deuxième partie de filtre peuvent comprendre une formation d'une couche de cuivre entre deux couches de nitrure de silicium.

On obtient ainsi un filtre qui utilise des matériaux généralement utilisés pour la fabrication des circuits intégrés.

On peut former la deuxième partie de filtre espacée verticalement de la première partie de filtre par une épaisseur optique de partie d'interconnexion comprise entre 0.4 et 3 fois ou entre 1 et 3 fois la longueur d'onde à filtrer dans le vide.

L'épaisseur optique correspond à la valeur du produit de l'épaisseur et de l'indice de réfraction.

On peut former la deuxième partie de filtre en formant un empilement de couches ayant une hauteur totale au dessus de la région supérieure d'interconnexion comprise par exemple entre 1000 et 1500 nanomètres.

Selon un autre aspect, il est proposé un circuit intégré comprenant un substrat, une partie d'interconnexion et un filtre optique multicouches, caractérisé en ce que le filtre optique multicouches comprend une première partie de filtre à l'intérieur de la partie d'interconnexion au dessus d'une zone photosensible située dans le substrat, et une deuxième partie de filtre au dessus de la première partie de filtre et de la partie d'interconnexion.

Ce circuit intégré est définie par la revendication 5.

La partie d'interconnexion peut comprendre une région inférieure d'interconnexion et une région supérieure d'interconnexion au dessus de la région inférieure d'interconnexion, la première partie de filtre comprenant une couche métallique inférieure au dessus de la zone photosensible et de la région inférieure d'interconnexion, et la deuxième partie de filtre peut comprendre une couche métallique supérieure au dessus de la région supérieure d'interconnexion et de la couche métallique inférieure de filtre.

La première et la deuxième partie de filtre peuvent comprendre au moins une couche métallique.

La première et la deuxième partie de filtre comprennent une couche de cuivre entre deux couches de nitrure de silicium.

La deuxième partie de filtre peut être espacée verticalement de la première partie de filtre par une épaisseur optique de partie d'interconnexion comprise entre 0.4 et 3 fois ou entre 1 et 3 fois la longueur d'onde à filtrer dans le vide.

La deuxième partie de filtre peut former un empilement de couches ayant une hauteur totale au dessus de la région supérieure d'interconnexion comprise entre 1000 et 1500 nanomètres.

D'autres avantages et caractéristiques de l'invention apparaîtront à l'étude de la description détaillée de modes de mise en oeuvre et de réalisation, pris à titre d'exemple non limitatifs et illustrés par les dessins annexés sur lesquels :

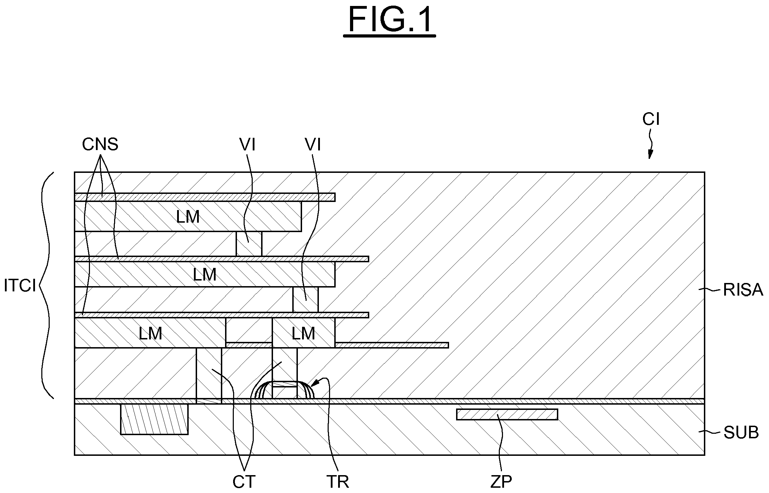

- les figures 1 à 4 illustrent différentes étapes d'un mode de mise en oeuvre d'un procédé de formation d'un filtre au sein d'un circuit intégré.

Sur la figure 1, on a représenté un circuit intégré CI comprenant un substrat SUB dans lequel on a formé une zone photosensible ZP, par exemple une zone photosensible ZP de photodiode à avalanche déclenchée par un photon individuel.

On a également formé un transistor TR ainsi qu'un ensemble de lignes métalliques LM reliées par des vias VI et connectées au substrat SUB par des contacts CT. Sur la figure 1, on a représenté trois par niveaux de métallisation comportant des lignes métalliques LM. Les niveaux de métallisation sont séparés par des couches de nitrure de silicium CNS (Si₃N₄) qui s'étendent dans les parties comprenant des lignes métalliques LM, mais pas au dessus de la zone photosensible ZP.

Les lignes métalliques LM sont formées dans une région isolante RISA, par exemple en dioxyde de silicium (SiO₂). L'ensemble formé par cette région isolante RISA et par les lignes métalliques LM reliées par des vias VI forme une région inférieure d'interconnexion ITCI.

Cette région inférieure d'interconnexion ITCI n'est pas une région d'interconnexion complète, comme décrit ci-après, au moins un autre niveau de métallisation sera formé au sein du circuit intégré CI.

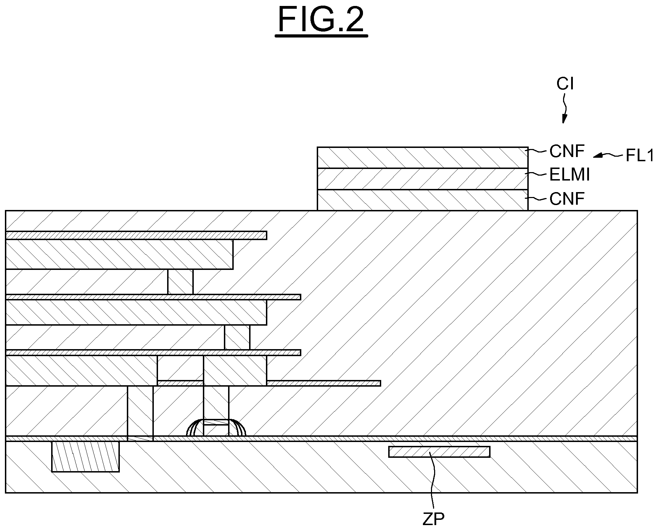

Comme illustré sur la figure 2, on peut former une première partie de filtre optique FL1 au-dessus de la région inférieure d'interconnexion ITCI. Cette première partie de filtre optique comprend par exemple une couche métallique en cuivre ELMI disposée entre deux couches de nitrure de silicium CNF. La formation de la première partie de filtre FL1 peut comprendre plusieurs étapes de dépôt, suivie par des étapes de gravure destinées à graver les couches de nitrure de silicium CNF et la couche métallique ELMI.

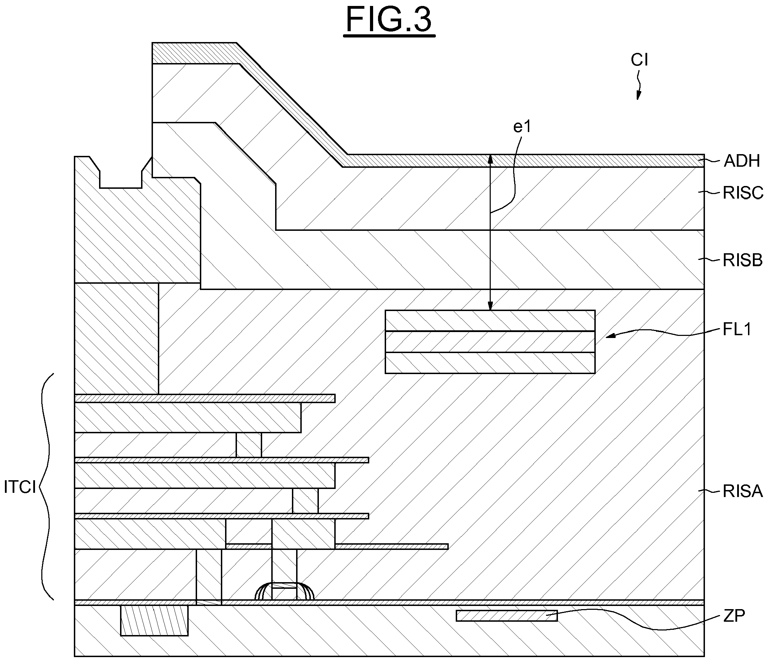

Sur la figure 3, on a représenté le circuit intégré CI après la formation d'une région supérieure d'interconnexion ITCS au-dessus de la région d'interconnexion ITCI et de la première partie de filtre FL1. On peut ainsi former un dernier niveau de métallisation, par exemple comprenant des zones accessibles pour la connexion du circuit intégré CI. On a également formé différentes couches au dessus de la région isolante RISA, ici une couche isolante supplémentaire RISB, pouvant comprendre du dioxyde de silicium dopé au phosphore (« PSG »), une couche isolante supplémentaire RISC, pouvant comprendre du nitrure de silicium, et enfin une couche fine de nitrure de silicium ADH pour favoriser l'adhérence de métaux.

On peut noter que l'épaisseur optique el de la région supérieure d'interconnexion ITCS située au dessus de la première partie de filtre FL1 est comprise entre 0.4 et 3 fois la longueur d'onde à filtrer dans le vide, ou entre 1 et 3 fois la longueur d'onde à filtrer dans le vide.

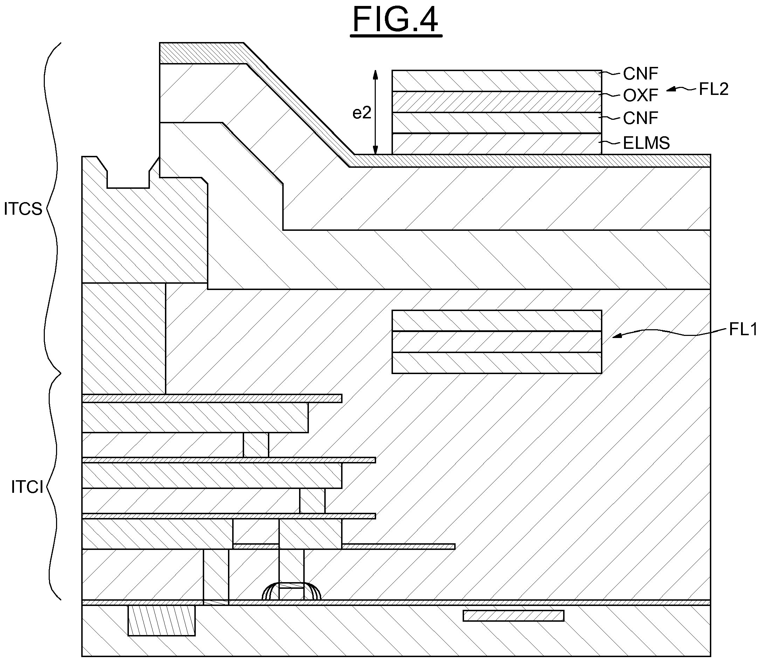

On peut ensuite former la deuxième partie de filtre FL2 (figure 4) au dessus de la région supérieure d'interconnexion ITCS et également au dessus de la première partie de filtre FL1. A cet effet, on peut former une couche métallique supérieure ELMS au sein d'un empilement de couches comprenant en outre des couches de dioxyde de silicium OXF et de nitrure de silicium CNF. La première partie de filtre FL1 et la deuxième partie de filtre FL2 forment un filtre optique multicouches.

A titre indicatif, l'épaisseur e2 de la deuxième partie de filtre peut être comprise entre 1000 et 1500 nanomètres. Ces épaisseurs correspondent aux épaisseurs maximales autorisées pour les filtres selon l'art antérieur réalisés intégralement au dessus des parties d'interconnexion. Ici, l'épaisseur totale du filtre est beaucoup plus importante puisque le filtre s'étend entre le milieu de la partie d'interconnexion et le haut de la deuxième partie de filtre FL2.

On peut noter que pour un filtre destiné à laisser passer les longueurs d'ondes situées dans la bande allant de 850 à 880 nanomètres, on obtient avec les filtres obtenus selon un aspect de l'invention une augmentation de la transmission pouvant atteindre 10%. Aussi, on obtient au voisinage de 800 nanomètres une baisse de la transmission de quelques pourcents.

Aussi, alors que dans l'art antérieur on forme deux couches de cuivre au dessus de la partie d'interconnexion dans un même empilement, on ne forme ici qu'une couche de cuivre au dessus de cette partie d'interconnexion. On n'obtient ainsi aucune sur-gravure de la couche de cuivre la plus haute du filtre, alors que tel est le cas pour les filtres selon l'art antérieur lorsque l'on délimite la couche la plus basse par gravure.

Selon un aspect de l'invention, on obtient une amélioration des propriétés optiques des filtres multicouches.

## Revendications

1. Procédé de réalisation d'un filtre optique multicouches au sein d'un circuit intégré (CI), le circuit intégré comprenant un substrat (SUB) essentiellement plan, une partie d'interconnexion (ITCI, ITCS) et une partie optique dans laquelle s'étendent des couches de la partie d'interconnexion, la partie optique comprenant ledit filtre optique (FL1, FL2) le procédé comprenant la formation d'une zone photosensible (ZP) dans le substrat (SUB),
**caractérisé en ce que** la réalisation du filtre optique comprend une formation d'une première partie de filtre (FL1) à l'intérieur de la partie optique en regard de la zone photosensible, et à une première distance du substrat (SUB), et une formation d'une deuxième partie de filtre (FL2) en regard de la première partie de filtre (FL1) et de la zone photosensible (ZP), à une deuxième distance du substrat (SUB) supérieure à la première distance, et
- une formation d'une région inférieure (ITCI) de la partie d'interconnexion (ITCI, ITCS) et de la partie optique entre le substrat (SUB) et la première distance du substrat(SUB), et
- une formation d'une couche métallique inférieure de filtre (ELMI) optique, en regard d'une partie de la région inférieure de la partie optique et de la zone photosensible, à une troisième distance du substrat (SUB) comprise entre la première
distance et la deuxième distance, la formation de la deuxième partie de filtre (FL2) comprenant :
- une formation d'une région supérieure (ITCS) de la partie d'interconnexion (ITCI, ITCS) entre la région inférieure de la partie d'interconnexion (ICTI) et une quatrième distance du substrat (SUB) supérieure à la deuxième distance, en regard de la couche métallique inférieure de filtre (ELMI) optique et de la région inférieure d'interconnexion, et
- une formation d'une couche métallique supérieure (ELMS) de filtre optique en regard de la partie optique et de la couche métallique inférieure de filtre (ELMI) optique, à la deuxième distance du substrat (SUB),
- les deux parties de filtre (FL1, FL2) étant séparées par certaines au moins des couches de la partie d'interconnexion s'étendant dans la partie optique,
les épaisseurs desdites couches de la partie d'interconnexion s'étendant dans la partie optique étant chosies pour optimiser les interférences globales dans ledit filtre optique (FL1, FL2)

2. Procédé selon la revendication 1, dans lequel la formation de la première partie de filtre et la formation de la deuxième partie de filtre comprennent une formation d'une couche de cuivre entre deux couches de nitrure de silicium.

3. Procédé selon l'une quelconque des revendications précédentes, dans lequel on forme la deuxième partie de filtre espacée dans une direction orthogonale au plan du substrat de la première partie de filtre par une épaisseur optique (e1) de partie d'interconnexion comprise entre 0.4 et 3 fois ou entre 1 et 3 fois la longueur d'onde à filtrer dans le vide, l'épaisseur optique correspondant à la différence entre la première distance et la deuxième distance.

4. Procédé selon l'une quelconque des revendications précédentes, dans lequel on forme la deuxième partie de filtre en formant un empilement de couches ayant une hauteur (e2) totale au delà de la région supérieure d'interconnexion par rapport à la zone photosensible comprise entre 1000 et 1500 nanomètres.

5. Circuit intégré (CI) comprenant un substrat (SUB) essentiellement plan, une partie d'interconnexion (ITCI, ITCS) et un filtre optique (FL1, FL2) multicouches, **caractérisé en ce que** le filtre optique multicouches comprend une première partie de filtre (FL1) à l'intérieur de la partie d'interconnexion (ITCI, ITCS), en regard, et à une première distance du substrat (SUB), le substrat (SUB) comprenant une zone photosensible (ZP) en regard de ladite première partie de filtre (FL1),
ledit filtre optique (Fl1, FL2) comprenant en outre une deuxième partie de filtre (FL2) en regard de la première partie de filtre (FL1) et de la zone photosensible (ZP) à une deuxième distance du substrat (SUB) supérieure à la première distance, et dans lequel la partie d'interconnexion (ITCI, ITCS) comprend une région inférieure d'interconnexion (ITCI) située entre la zone photosensible et la première distance du substrat (SUB) et une région supérieure d'interconnexion (ITCS) au delà de la région inférieure d'interconnexion (ITCI) par rapport au substrat (SUB), la première partie de filtre (FL1) comprenant une couche métallique inférieure (ELMI) en regard de la zone photosensible et d'une partie de la région inférieure d'interconnexion dépourvue de métal à une troisième distance du substrat (SUB) comprise entre la première distance et la deuxième distance, et la deuxième partie de filtre (FL2) comprend une couche métallique supérieure (ELMS) en regard de la zone photosensible (ZP) et de la couche métallique inférieure (ELMI) de filtre, située à la deuxième distance du substrat (SUB),
les deux parties de filtre (FL1, FL2) étant séparées par certaines des couches de la partie d'interconnexion dont les épaisseurs sont chosies pour optimiser les interférences globales dans ledit filtre optique (FL1, FL2).

6. Circuit intégré selon la revendication 5, dans lequel la première et la deuxième partie de filtre comprennent une couche de cuivre entre deux couches de nitrure de silicium.

7. Circuit intégré selon l'une quelconque des revendications 5 et 6, dans lequel la deuxième partie de filtre est espacée dans une direction orthogonale au plan du substrat de la première partie de filtre par une épaisseur optique (e1) de partie d'interconnexion comprise entre 0.4 et 3 fois ou entre 1 et 3 fois la longueur d'onde à filtrer dans le vide, l'épaisseur optique correspondant à la différence entre la première distance et la deuxième distance.

8. Circuit intégré selon l'une quelconque des revendications 5 et 7, dans lequel la deuxième partie de filtre forme un empilement de couches ayant une hauteur (e2) totale au delà de la région supérieure d'interconnexion par rapport à la zone photosensible comprise entre 1000 et 1500 nanomètres.

## Patentansprüche

1. Verfahren zur Herstellung eines mehrschichtigen optischen Filters innerhalb eines integrierten Schaltkreises (CI), wobei der integrierte Schaltkreis ein im Wesentlichen ebenes Substrat (SUB), einen Verbindungsteil (ITCI, ITCS) und einen optischen Teil, in welchem sich Schichten des Verbindungsteils erstrecken, umfasst, wobei der optische Teil das optische Filter (FL1, FL2) umfasst, wobei das Verfahren die Ausbildung einer photoempfindlichen Zone (ZP) in dem Substrat (SUB) umfasst,
**dadurch gekennzeichnet, dass** die Herstellung des optischen Filters eine Ausbildung eines ersten Filterteils (FL1) im Inneren des optischen Teils gegenüber der photoempfindlichen Zone und in einem ersten Abstand von dem Substrat (SUB) und eine Ausbildung eines zweiten Filterteils (FL2) gegenüber dem ersten Filterteil (FL1) und der photoempfindlichen Zone (ZP) in einem zweiten Abstand von dem Substrat (SUB), der größer als der erste Abstand ist, umfasst, und
- eine Ausbildung eines unteren Bereichs (ITCI) des Verbindungsteils (ITCI, ITCS) und des optischen Teils zwischen dem Substrat (SUB) und dem ersten Abstand von dem Substrat (SUB), und
- eine Ausbildung einer unteren Metallschicht des optischen Filters (ELMI) gegenüber einem Teil des unteren Bereichs des optischen Teils und der photoempfindlichen Zone in einem dritten Abstand von dem Substrat (SUB), der zwischen dem ersten Abstand und dem zweiten Abstand liegt,
wobei die Ausbildung des zweiten Filterteils (FL2) umfasst:
- eine Ausbildung eines oberen Bereichs (ITCS) des Verbindungsteils (ITCI, ITCS) zwischen dem unteren Bereich des Verbindungsteils (ITCI) und einem vierten Abstand von dem Substrat (SUB), der größer als der zweite Abstand ist, gegenüber der unteren Metallschicht des optischen Filters (ELMI) und dem unteren Verbindungsbereich, und
- eine Ausbildung einer oberen Metallschicht des optischen Filters (ELMS) gegenüber dem optischen Teil und der unteren Metallschicht des optischen Filters (ELMI) in dem zweiten Abstand von dem Substrat (SUB),
- wobei die zwei Filterteile (FL1, FL2) durch wenigstens einige der Schichten des Verbindungsteils getrennt sind, die sich in dem optischen Teil erstrecken,
wobei die Dicken der Schichten des Verbindungsteils, die sich in dem optischen Teil erstrecken, so gewählt sind, dass die Gesamtinterferenzen in dem optischen Filter (FL1, FL2) optimiert werden.

2. Verfahren nach Anspruch 1, wobei die Ausbildung des ersten Filterteils und die Ausbildung des zweiten Filterteils eine Ausbildung einer Kupferschicht zwischen zwei Schichten Siliziumnitrid umfassen.

3. Verfahren nach einem der vorhergehenden Ansprüche, wobei der zweite Filterteil in einer zur Ebene des Substrats orthogonalen Richtung von dem ersten Filterteil durch eine optische Dicke (e1) des Verbindungsteils beabstandet ausgebildet wird, die zwischen dem 0,4- und 3-fachen oder zwischen dem 1- und 3-fachen der zu filternden Wellenlänge im Vakuum liegt, wobei die optische Dicke der Differenz zwischen dem ersten Abstand und dem zweiten Abstand entspricht.

4. Verfahren nach einem der vorhergehenden Ansprüche, wobei der zweite Filterteil ausgebildet wird, indem ein Schichtenstapel gebildet wird, der eine Gesamthöhe (e2) über den oberen Verbindungsbereich hinaus in Bezug auf die photoempfindliche Zone aufweist, die zwischen 1000 und 1500 Nanometern beträgt.

5. Integrierter Schaltkreis (CI), welcher ein im Wesentlichen ebenes Substrat (SUB), einen Verbindungsteil (ITCI, ITCS) und ein mehrschichtiges optisches Filter (FL1, FL2) umfasst, **dadurch gekennzeichnet, dass** das mehrschichtige optische Filter einen ersten Filterteil (FL1) im Inneren des Verbindungsteils (ITCI, ITCS), gegenüber dem Substrat (SUB) und in einem ersten Abstand von ihm, umfasst, wobei das Substrat (SUB) eine photoempfindliche Zone (ZP) gegenüber dem ersten Filterteil (FL1) umfasst, wobei das optische Filter (Fl1, FL2) außerdem einen zweiten Filterteil (FL2) gegenüber dem ersten Filterteil (FL1) und der photoempfindlichen Zone (ZP) in einem zweiten Abstand von dem Substrat (SUB), der größer als der erste Abstand ist, umfasst,
und wobei der Verbindungsteil (ITCI, ITCS) einen unteren Verbindungsbereich (ITCI), der sich zwischen der photoempfindlichen Zone und dem ersten Abstand von dem Substrat (SUB) befindet, und einen oberen Verbindungsbereich (ITCS) in Bezug auf das Substrat (SUB) jenseits des unteren Verbindungsbereichs (ITCI) umfasst,
wobei der erste Filterteil (FL1) eine untere Metallschicht (ELMI) gegenüber der photoempfindlichen Zone und einem metallfreien Teil des unteren Verbindungsbereichs in einem dritten Abstand von dem Substrat (SUB), der zwischen dem ersten Abstand und dem zweiten Abstand liegt, umfasst, und der zweite Filterteil (FL2) eine obere Metallschicht (ELMS) gegenüber der photoempfindlichen Zone (ZP) und der unteren Metallschicht (ELMI) des Filters umfasst, die sich in dem zweiten Abstand von dem Substrat (SUB) befindet,
wobei die zwei Filterteile (FL1, FL2) durch einige der Schichten des Verbindungsteils getrennt sind, deren Dicken so gewählt sind, dass die Gesamtinterferenzen in dem optischen Filter (FL1, FL2) optimiert werden.

6. Integrierter Schaltkreis nach Anspruch 5, wobei der erste und der zweite Filterteil eine Kupferschicht zwischen zwei Schichten Siliziumnitrid umfassen.

7. Integrierter Schaltkreis nach einem der Ansprüche 5 und 6, wobei der zweite Filterteil in einer zur Ebene des Substrats orthogonalen Richtung von dem ersten Filterteil durch eine optische Dicke (e1) des Verbindungsteils beabstandet ist, die zwischen dem 0,4- und 3-fachen oder zwischen dem 1- und 3-fachen der zu filternden Wellenlänge im Vakuum liegt, wobei die optische Dicke der Differenz zwischen dem ersten Abstand und dem zweiten Abstand entspricht.

8. Integrierter Schaltkreis nach einem der Ansprüche 5 und 7, wobei der zweite Filterteil einen Schichtenstapel bildet, der eine Gesamthöhe (e2) über den oberen Verbindungsbereich hinaus in Bezug auf die photoempfindliche Zone aufweist, die zwischen 1000 und 1500 Nanometern beträgt.

## Claims

1. Process for fabricating a multilayer optical filter within an integrated circuit (CI), the integrated circuit comprising a substantially planar substrate (SUB), an interconnect portion (ITCI, ITCS) and an optical portion into which layers of the interconnect portion extend, the optical portion comprising said optical filter (FL1, FL2), the process comprising the formation of a photosensitive zone (ZP) in the substrate (SUB),
**characterized in that** the fabrication of the optical filter comprises an operation of forming a first filter portion (FL1) within the optical portion facing the photosensitive zone, and a first distance away from the substrate (SUB), and an operation of forming a second filter portion (FL2) facing the first filter portion (FL1) and the photosensitive zone (ZP), a second distance away from the substrate (SUB), which second distance is greater than the first distance, and
- an operation of forming a lower region (ITCI) of the interconnect portion (ITCI, ITCS) and the optical portion between the substrate (SUB) and the first distance away from the substrate (SUB), and
- an operation of forming a lower metal optical filter layer (ELMI), facing a portion of the lower region of the optical portion and the photosensitive zone, a third distance away from the substrate (SUB), which third distance is between the first distance and the second distance,
the operation of forming the second filter portion (FL2) comprising:
- an operation of forming an upper region (ITCS) of the interconnect portion (ITCI, ITCS) between the lower region of the interconnect portion (ICTI) and a fourth distance away from the substrate (SUB), which fourth distance is greater than the second distance, facing the lower metal optical filter layer (ELMI) and the lower interconnect region, and
- an operation of forming an upper metal optical filter layer (ELMS) facing the optical portion and the lower metal optical filter layer (ELMI), the second distance away from the substrate (SUB),
- the two filter portions (FL1, FL2) being separated by at least some of the layers of the interconnect portion extending into the optical portion, the thicknesses of said layers of the interconnect portion extending into the optical portion being chosen so as to optimize the overall interference in said optical filter (FL1, FL2).

2. Process according to Claim 1, wherein the operation of forming the first filter portion and the operation of forming the second filter portion comprise an operation of forming a layer of copper between two layers of silicon nitride.

3. Process according to either of the preceding claims, wherein the second filter portion is formed separated in a direction orthogonal to the plane of the substrate from the first filter portion by an optical thickness (e1) of interconnect portion of between 0.4 and 3 times or between 1 and 3 times the wavelength to be filtered in vacuum, the optical thickness corresponding to the difference between the first distance and the second distance.

4. Process according to any one of the preceding claims, wherein the second filter portion is formed by forming a stack of layers having a total height (e2) above the upper interconnect region in relation to the photosensitive zone of between 1000 and 1500 nanometres.

5. Integrated circuit (CI) comprising a substantially planar substrate (SUB), an interconnect portion (ITCI, ITCS) and a multilayer optical filter (FL1, FL2), **characterized in that** the multilayer optical filter comprises a first filter portion (FL1) within the interconnect portion (ITCI, ITCS), facing, and a first distance away from, the substrate (SUB), the substrate (SUB) comprising a photosensitive zone (ZP) facing said first filter portion (FL1), said optical filter (Fl1, FL2) further comprising a second filter portion (FL2) facing the first filter portion (FL1) and the photosensitive zone (ZP) a second distance away from the substrate (SUB), which second distance is greater than the first distance, and wherein the interconnect portion (ITCI, ITCS) comprises a lower interconnect region (ITCI) that is located between the photosensitive zone and the first distance away from the substrate (SUB) and an upper interconnect region (ITCS) above the lower interconnect region (ITCI) in relation to the substrate (SUB), the first filter portion (FL1) comprising a lower metal layer (ELMI) facing the photosensitive zone and a portion of the lower interconnect region that is without metal a third distance away from the substrate (SUB), which third distance is between the first distance and the second distance, and the second filter portion (FL2) comprises an upper metal layer (ELMS) facing the photosensitive zone (ZP) and the lower metal filter layer (ELMI), located the second distance away from the substrate (SUB), the two filter portions (FL1, FL2) being separated by some of the layers of the interconnect portion, the thicknesses of which are chosen so as to optimize the overall interference in said optical filter (FL1, FL2).

6. Integrated circuit according to Claim 5, wherein the first and the second filter portion comprise a layer of copper between two layers of silicon nitride.

7. Integrated circuit according to either of Claims 5 and 6, wherein the second filter portion is separated in a direction orthogonal to the plane of the substrate from the first filter portion by an optical thickness (e1) of interconnect portion of between 0.4 and 3 times or between 1 and 3 times the wavelength to be filtered in vacuum, the optical thickness corresponding to the difference between the first distance and the second distance.

8. Integrated circuit according to either of Claims 5 and 7, wherein the second filter portion forms a stack of layers having a total height (e2) above the upper interconnect region in relation to the photosensitive zone of between 1000 and 1500 nanometres.
